# EUROPEAN PATENT SPECIFICATION

(11) **EP 4 280 292 B1**
(45) Date of publication and mention of the grant of the patent: **29.04.2026**
(21) Application number: 21918333.2
(22) Date of filing: 14.01.2021
(51) Int. Cl.: H10N 60/20, H10N 70/20, H10D 30/67

(54) **SOLID OXYGEN ION CONDUCTOR BASED FIELD EFFECT TRANSISTOR AND MANUFACTURING METHOD THEREFOR**
AUF EINEM FESTEN SAUERSTOFFIONENLEITER BASIERENDER FELDEFFEKTTRANSISTOR UND HERSTELLUNGSVERFAHREN DAFÜR
TRANSISTOR À EFFET DE CHAMP À BASE DE CONDUCTEUR D'IONS D'OXYGÈNE SOLIDE ET SON PROCÉDÉ DE FABRICATION

(43) Date of publication of application: 22.11.2023
(73) Proprietor: University of Science and Technology of China, Anhui 230026 (CN)
(72) Inventor: CHEN, Xianhui, Hefei, Anhui 230026 (CN); LEI, Bin, Hefei, Anhui 230026 (CN); MA, Donghui, Hefei, Anhui 230026 (CN); LIU, Shihao, Hefei, Anhui 230026 (CN)
(74) Representative: Grünecker Patent- und Rechtsanwälte PartG mbB
(86) International application number: PCT/CN2021/071650
(87) International publication number: WO 2022/151122

(56) References cited:
- CN-A- 101 124 679
- CN-A- 105 633 280
- CN-A- 106 024 901
- JP-A- 2015 012 049
- JP-A- 2017 199 825
- US-A1- 2006 255 392
- TSUCHIYA TAKASHI ET AL: "All-solid-state electric-double-layer transistor based on oxide ion migration in Gd-doped CeO 2 on SrTiO 3 single crystal", APPLIED PHYSICS LETTERS, 12 August 2013 (2013-08-12), pages 73110, XP055951490, Retrieved from the Internet <URL:https://doi.org/10.1063/1.4818736> [retrieved on 20220815], DOI: 10.1063/1.4818736
- TSUCHIYA TAKASHI, TERABE KAZUYA, AONO MASAKAZU: "All-solid-state electric-double-layer transistor based on oxide ion migration in Gd-doped CeO 2 on SrTiO 3 single crystal", APPLIED PHYSICS LETTERS, 12 August 2013 (2013-08-12), pages 73110, XP055951490, DOI: 10.1063/1.4818736

## Description

### TECHNICAL FIELD

The present disclosure relates to fields of physics, material science and semiconductor technology, and in particular, to a new solid oxygen ionic conductor-based field effect transistor and its manufacturing method.

### BACKGROUND

Regulating physical properties of oxides is a hot topic in the study of the condensed matter physics, and how to realize effective regulation of physical properties has always been a research focus of scientists. Electrostatic regulation of carrier concentration in oxide materials is an effective method to control the physical property of oxides. By simply changing the DC bias voltage, it is easy to control carrier concentration without introducing structural disorder like chemical doping. Unfortunately, due to a low dielectric constant and a breakdown voltage, the maximum carrier concentration introduced by a traditional all-solid-state field-effect transistor that uses solid-state oxides such as silicon dioxide, strontium titanate and the like as gate dielectrics is less than 10¹³ cm⁻². In order to overcome these limitations, non-solid-state electrolytes, including the ionic liquid and the ionic gel, have been used in the electric-double-layer field-effect transistor, and the adjustable carrier concentration has reached 10¹⁴ cm⁻². However, due to the liquid nature of the electrolyte, there are great limitations on the stability, characterization and device application of the material.

The solid-state proton conductor based field-effect transistor developed by using porous solid-state oxide proton conductor films such as silicon dioxide, alumina and the like as solid-state electrolytes avoids use of liquids, but still has problems. Because the proton conductivity of the porous solid-state oxide proton conductor films is easily lost, the proton conductivity only exists when water molecules are adsorbed on the surface of the thin film, thus extremely depending on the surrounding gas atmosphere. In addition, because of the water decomposition, compared with other electrolytes, the electrochemical window of porous solid-state oxide proton conductor film is very small, only 1.23 V, which may limit its regulation ability.

Patent "Method for Regulating Carrier Concentration of Material, Field Effect Transistor and Manufacturing Method" (Patent No. CN 201610585699.1) proposes a gate voltage regulation technology of field effect transistor based on a solid-state lithium ionic conductor as the gate dielectric, which may realize a reversible regulation of the carrier concentration in a wide range (to 10¹⁵ cm⁻²) and successfully break through a bottleneck of a traditional field effect transistor and a traditional ionic liquid electric double-layer field effect transistor in carrier concentration regulation (to 10¹⁴ cm⁻²). However, for oxides, the injected lithium ion is no different from an impurity, which may make the regulation not clean enough. Moreover, The insertion or removal of lithium ions may also have an impact on the structure of the oxide, which may reduce the lifetime of the device.

In recent years, ionic liquids have another application. With the ionic liquid as the gate dielectric, the oxide has been tuned by electric field under an applied bias voltage at room temperature. Residual water in the ionic liquid may be electrolyzed into protons and oxygen ions, and the oxygen ions may diffuse into the oxide, and thus effectively regulate the physical properties of the oxide. However, the electrolyte used in this method is still liquid, which may greatly limit the stability of the sample, the characterization and the application of the device. In addition, the regulation of the physical property by electrolyzing the residual water in the ionic liquid into protons and oxygen ions may be caused by the uneven diffusion of its concentration, and the regulation is uncontrollable and irreversible, In addition, the oxygen ion has a large ionic radius and a long diffusion time, so it usually takes several days to realize a considerable regulatory effect, which may limit their application in devices.

In summary, the existing electric field control technology of field-effect transistor has some defects and limitations to some extent for the oxide.

JP 2017 199825 A discloses a three-terminal element having a new configuration and using an electric double layer. JP 2015 012049 A provides an all solid type electric double layer field effect element.

### SUMMARY

In view of this, in order to effectively regulate the physical properties of oxides, the present disclosure provides a new solid oxygen ionic conductor based field-effect transistor and its manufacturing method.

In order to realize the above-mentioned objects, on one hand, the present invention provides a solid oxygen ionic conductor based field-effect transistor according to claim 1, including:
a substrate; a gate dielectric layer located on the substrate, where the gate dielectric layer is a solid oxygen ionic conductor thin film; a channel layer covered on a part of the gate dielectric layer; and a source electrode and a drain electrode respectively located on the gate dielectric layer not covered by the channel layer and on a part of the channel layer. The material of the channel layer is an oxide thin film or thin flake, including one of: strontium cobaltate, or strontium iridium oxide; and the thickness of the channel layer is in a range of 5 nm to 30 nm.

According to embodiments of the present invention, the substrate may be a metal conductive substrate, including one of niobium-doped strontium titanate or indium tin oxide conductive glass.

According to embodiments of the present invention, the material of the solid oxygen ionic conductor thin film may be gadolinium-doped ceric oxide; and the thickness of the gate dielectric layer is in a range of 400 nm to 1 µm.

According to embodiments of the present invention, both of the source and drain electrodes are one of the metal elemental films or indium tin oxide conductive films.

On the other hand, the present invention further provides a method of manufacturing a field-effect transistor according to claim 5, including: providing a metal conductive substrate as the gate electrode of the field-effect transistor; manufacturing a solid oxygen ionic conductor thin film based gate dielectric layer on the surface of the metal conductive substrate; manufacturing a channel layer on the surface of the gate dielectric layer by using thin film growing and etching process or material mechanical peeling and transferring technology, which covers a portion of the gate dielectric layer, wherein the material of the channel layer is an oxide thin film or thin flake, comprising one of: strontium cobaltate or strontium iridium oxide; and the thickness of the channel layer is in a range of 5 nm to 30 nm; and manufacturing a source electrode and a drain electrode on the gate dielectric layer not covered by the channel layer and on a part of the channel layer by using a coating process.

According to embodiments of the present invention, the preparation process of manufacturing the solid oxygen ionic conductor thin film based gate dielectric layer on the surface of the metal conductive substrate may include one of magnetron sputtering or pulsed laser deposition.

According to embodiments of the present invention, the preparation process of manufacturing the gate dielectric layer may include that: the temperature at which the metal conductive substrate is heated is in a range of 600 °C to 750 °C; the power density is in a range of 1.5 W/cm² to 3.5 W/cm²; the distance between the target and the metal conductive substrate is in a range of 5 cm to 12 cm; and the gas flow ratio of process gas to reaction gas is in a range of 2:1 to 3:1.

According to embodiments of the present invention, the process gas may be argon and the reaction gas may be oxygen.

According to embodiments of the present invention, the thin film growing and etching process may include one of the argon ion etching process, reactive ion beam etching process or focused ion beam etching process; the material mechanical peeling and transferring technology may include one of dry transfer or wet transfer; and the coating process may include one of electron beam evaporation process or thermal evaporation process.

### BRIEF DESCRIPTION OF THE DRAWINGS

FIG. 1 schematically shows the structural schematic diagram of a solid oxygen ionic conductor based field-effect transistor according to embodiments of the present invention;
FIG. 2 schematically shows a flowchart of a method of manufacturing a solid oxygen ionic conductor based field-effect transistor according to embodiments of the present invention;
FIG. 3 schematically shows the temperature dependent resistance of the channel material Bi₂Sr₂CaCu₂0_{8+δ} thin layer under different gate voltages according to an example of the present disclosure;
FIG. 4 schematically shows the temperature dependent resistance of the channel material SrCoO_{2.5} thin film under different gate voltages according to Embodiment 1 of the present invention;
FIG. 5 schematically shows the temperature dependent resistance of the channel material Sr₂IrO₄ thin film under different gate voltages according to Embodiment 2 of the present invention.

### DETAILED DESCRIPTION OF EMBODIMENTS

In order to make objectives, technical solutions and advantages of the present invention clearer, the present invention will be further described in detail below with reference to the specific embodiments, examples and accompanying drawings. In the following "present disclosure" is used as synonym for "present invention". Examples outside the scope of the "present invention/disclosure" are indicated.

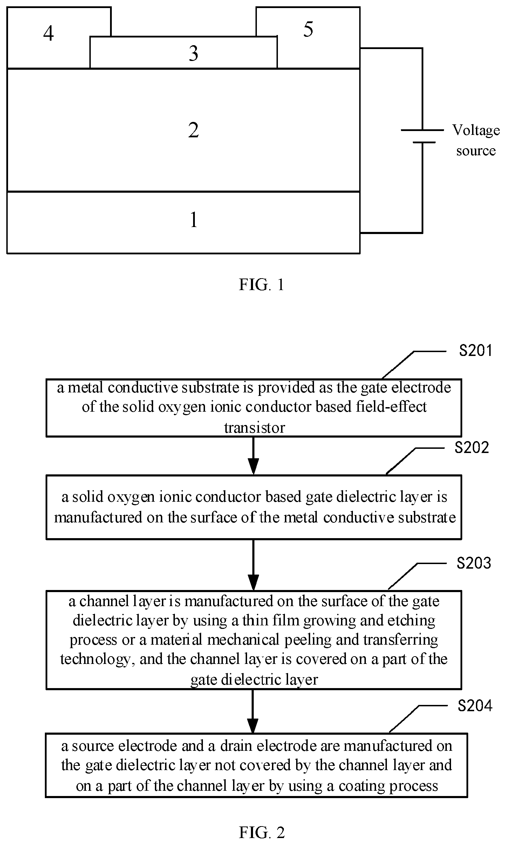

It should be noted that the accompanying drawings of the specification, which constitute a part of the present disclosure, are used to provide a further understanding of the present disclosure, and illustrative embodiments of the present disclosure and descriptions thereof are intended to explain the present disclosure and do not constitute an improper limitation on the present disclosure. FIG. 1 schematically shows a structural schematic diagram of a solid oxygen ionic conductor based field-effect transistor according to embodiments of the present disclosure.

As shown in FIG. 1, a solid oxygen ionic conductor based field-effect transistor provided by the present disclosure includes: a substrate 1, a gate dielectric layer 2, a channel layer 3, a source electrode 4 and a drain electrode 5. The gate dielectric layer 2 is located on the substrate 1, and the gate dielectric layer 2 is a solid-sate oxygen ionic conductor thin film; the channel layer 3 is covered on a part of the gate dielectric layer 2, and the channel layer 3 is an oxide thin film or a thin flake; and the source electrode 4 and the drain electrode 5 are respectively located on the gate dielectric layer 2 not covered by the channel layer 3 and on a part of the channel layer 3.

According to embodiments of the present disclosure, the substrate 1 is a metal conductive substrate, including but not limited to one of niobium-doped strontium titanate (Nb doped SrTiO₃) or indium tin oxide (ITO) conductive glass. The metal conductive substrate may be used as the gate electrode.

According to embodiments of the present disclosure, the gate dielectric layer 2 is the solid oxygen ionic conductor thin film, and the material of the solid-state oxygen ionic conductor film is gadolinium-doped ceric oxide (Gd doped CeO₂).

According to embodiments of the present disclosure, the thickness of the gate dielectric layer 2 is in a range of 400 nm to 1 µm. On the one hand, the thickness may ensure that the gate dielectric layer is not easily broken down. On the other hand, the thickness may enable growth time of the gate dielectric thin film not to be too long, and may not easily damage the target.

Compared with other solid-sate oxygen ionic conductors, the gadolinium-doped ceric oxide has a considerable oxygen ion conductivity at room temperature and may regulate the physical properties of oxides at room temperature.

According to embodiments of the present disclosure, the channel layer 3 is the oxide thin film or the thin flake, including one of strontium cobaltate (SrCoO_{2.5}) and strontium iridium oxide (Sr₂IrO₄), and the thickness of the channel layer 3 is in a range of 5 nm to 30 nm.

According to embodiments of the present disclosure, both of the source electrode 4 and the drain electrode 5 are metal elemental films or indium tin oxide conductive films.

According to embodiments of the present disclosure, by providing a new solid-state oxygen ionic conductor based field-effect transistor, the use of a solid oxygen ion conductor as the gate dielectric layer may solve the problem of electrochemical instability between the gate dielectric and the oxide material, and the physical properties of oxides may be effectively regulated.

Based on the above-mentioned solid oxygen ionic conductor based field-effect transistor, the present disclosure further provides a method of manufacturing a solid oxygen ionic conductor based field-effect transistor.

FIG. 2 schematically shows a flowchart of a method of manufacturing a solid oxygen ionic conductor based field-effect transistor according to embodiments of the present disclosure. As shown in FIG. 2, the method includes operations S201 to S204.

In operation S201, a metal conductive substrate is provided as the gate electrode of the solid oxygen ionic conductor based field-effect transistor.

According to embodiments of the present disclosure, the metal conductive substrate may be niobium-doped strontium titanate or indium tin oxide conductive glass. The oxygen plasma cleaning is performed on the metal conductive substrate to prepare for the growth of the gate dielectric layer.

In operation S202, a solid oxygen ionic conductor based gate dielectric layer is manufactured on the surface of the metal conductive substrate.

According to embodiments of the present disclosure, the gate dielectric layer is grown on the metal conductive substrate by using the thin film growth process. The thin film growth process includes but is not limited to magnetron sputtering process or pulsed laser deposition process.

According to embodiments of the present disclosure, the process of manufacturing the gate dielectric layer by using the magnetron sputtering process is that:
a temperature at which the metal conductive substrate is heated is in a range of 600 °C to 750 °C;
a power density is in a range of 1.5 W/cm² to 3.5 W/cm²;
a distance between a target and the metal conductive substrate is in a range of 5 cm to 12 cm; and
a gas flow ratio of process gas to reaction gas is in a range of 2:1 to 3:1.

According to embodiments of the present disclosure, the process gas is argon, and the reaction gas is oxygen.

According to embodiments of the present disclosure, the use of the solid-state oxygen ionic conductor as the gate dielectric layer may solve the problem of electrochemical instability between the gate dielectric layer and the channel layer oxide material. At the same time, the use of the solid-state oxygen ionic conductor may be easily applied to the device, and the back gate configuration of the field-effect transistor may be easily characterized.

In operation S203, a channel layer is manufactured on the surface of the gate dielectric layer by using a thin film growing and etching process or a material mechanical peeling and transferring technology, and the channel layer is covered on a part of the gate dielectric layer.

According to embodiments of the present disclosure, the channel layer is manufactured on the gate dielectric layer, and part of the channel layer is etched by using the thin film growth etching process, including but not limited to argon ion etching process, reactive ion beam etching process or focused ion beam etching process, so as to expose part of the gate dielectric layer for manufacturing the source electrode and the drain electrode.

A certain size of oxide materials, such as strontium cobaltate or strontium iridium oxide that are required to manufacture the channel layer are selected in advance by using the material mechanical peeling and transferring technology, and the oxide materials are transferred to the gate dielectric layer of the solid-state oxygen ionic conductor thin film by the dry transfer or wet transfer technology to form the channel layer. The channel layer covers part of the gate dielectric layer, and the gate dielectric layer not covered by the channel layer is used to manufacture the source electrode and drain electrode.

In operation S204, a source electrode and a drain electrode are manufactured on the gate dielectric layer not covered by the channel layer and on a part of the channel layer by using a coating process.

According to embodiments of the present disclosure, the coating process includes electron beam evaporation process or thermal evaporation process.

According to embodiments of the present disclosure, the use of the solid-state oxygen ionic conductor as the gate dielectric layer may solve the problem of electrochemical instability between the gate dielectric and the oxide material, making it easy to apply to devices, and able to regulate the physical properties of oxides at room temperature. The movement of oxygen ions is a mechanism of vacancies or gaps, both of which are conductive mechanisms of the body, independent of surface adsorption and working environment. Since the oxide thin film is relatively stable under voltage and has a wide electrochemical window, a wide range of carrier concentration regulation may be realized. For oxides, the injected oxygen ions are not impurities and may not destroy the structure of the material, making it a clean regulatory method.

In order to more clearly describe the method of manufacturing the solid-state oxygen ionic conductor based field-effect transistor of the present disclosure, the present disclosure provides specific embodiments for further specific explanation. It should be noted that the descriptions of these specific embodiments are only exemplary, and are not intended to limit the scope of protection of the present disclosure.

### Example 1

In the example outside the scope of the present invention, the material of the channel layer is Bi₂Sr₂CaCu₂O_{8+δ} thin layer, and a solid oxygen ionic conductor based field-effect transistor thereof is manufactured according to the following steps S1 to S4.

In S1, niobium-doped strontium titanate (Nb doped SrTiO₃) is selected as the substrate with a thickness of 0.5 mm and a size of 5×5 mm², and the oxygen plasma cleaning is performed at a power of 150 W for 10 minutes.

In S2, the gadolinium-doped ceric oxide (Gd doped CeO₂) thin film with a thickness of 700 nm is grown as the gate dielectric layer on the niobium-doped strontium titanate substrate by using the magnetron sputtering film growth process.

Process conditions for manufacturing the gate dielectric layer are as follows: the gadolinium-doped ceric oxide is used as the target, the distance between the target and the substrate is 10 cm, the temperature of the substrate is 700 °C, the total pressure of vacuum chamber is 1.2 Pa, the flow ratio of argon to oxygen introduced is 3:1, the sputtering power is 60 W, and growth time is 12 hours.

In S3, a piece of Bi₂Sr₂CaCu₂O_{8+δ}single crystal is selected, stuck on an adhesive tape, and then stuck on a polydimethylsiloxane (PDMS) thin film after repeatedly cleaving with the adhesive tape, a thin-layer sample with a thickness of 9 nm, a length of 30 µm and a width of 20 µm is found under an optical microscope after tearing off the adhesive tape. Then, the thin-layer sample is transferred using a transfer table from the polydimethylsiloxane thin film to a surface on which the gadolinium-doped ceric oxide thin film is used as the gate dielectric layer as the channel layer by using a dry transfer method.

In S4, an Au film is deposited as the source electrode and the drain electrode on the surface on which the gadolinium-doped ceric oxide thin film is used as the gate dielectric layer and which is not covered by the channel layer and on a part of the channel layer by using the thermal evaporation process. The Au film has a thickness of 30 nm and an evaporation rate of 0.3 Å/s.

A field-effect transistor with a back gate structure in which a gadolinium-doped ceric oxide solid-state oxygen ionic conductor film is used as the gate dielectric layer and Bi₂Sr₂CaCu₂O_{8+δ} thin layer is used as the channel layer may be acquired through the above-mentioned steps.

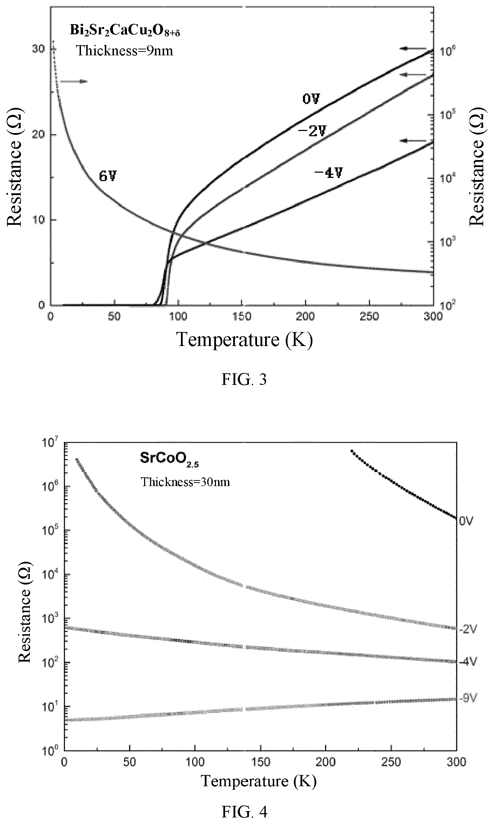

In order to verify the regulation performance of the field-effect transistor on the channel material, the device is placed in a comprehensive physical property measurement system (PPMS), vacuum is pumped to less than 1 millibar, temperature is stabilized at 300 K, the bias voltage is applied between the gate electrode and the source electrode by using a digital source meter, and the resistance of the channel material is measured by using a lock-in amplifier. For example, FIG. 3 schematically shows the temperature dependent resistance of the channel material Bi₂Sr₂CaCu₂0_{8+δ} thin layer under different gate voltages according to Example 1.

As shown in FIG. 3, when no bias voltage is applied, the sample is superconducting, and the zero resistance temperature of the sample is 85 K, which is close to the optimal doping. When a positive bias voltage of 6 V is applied, the electric field drives oxygen out of the sample, and the sample is doped with electrons. The room temperature resistance of the sample increases by an order of magnitude, and a cooling shows that the sample becomes an insulator. Then, a negative bias voltage is applied to the sample. Under the applied electric field, oxygen ions in the gadolinium-doped ceric oxide thin film are injected into the sample, the sample is hole-doped, and the sample gradually changes from the insulating state to the superconducting state. When the bias voltage is -2 V, the sample realize the optimal superconductivity with a zero resistance temperature of 90 K. When the bias voltage is -4 V, the sample is in an over-doped state, and the zero resistance temperature drops to 81 K.

From an experimental result, it can be seen that the physical properties of the channel material has been well regulated by the electric field, which shows the excellent performance of the solid oxygen ionic conductor based field-effect transistor.

### Embodiment 1

In the embodiment, the material of the channel layer is SrCoO_{2.5} thin film, and a solid oxygen ionic conductor based field-effect transistor thereof is manufactured according to the following steps.

In S1, niobium-doped strontium titanate (Nb doped SrTiO₃) is selected as the substrate with a thickness of 0.5 mm and a size of 5×5 mm², and the oxygen plasma cleaning is performed at a power of 150 W for 10 minutes.

In S2, the gadolinium-doped ceric oxide (Gd doped CeO₂) thin film with a thickness of 1 µm is grown as the gate dielectric layer on the niobium-doped strontium titanate substrate by using the magnetron sputtering film growth process.

According to embodiments of the present disclosure, process conditions for manufacturing the gate dielectric layer are as follows: the gadolinium-doped ceric oxide is used as the target, the distance between the target and the substrate is 10 cm, the temperature of the substrate is 700 °C, the total pressure of a vacuum chamber is 1.2 Pa, the flow ratio of argon to oxygen introduced is 3:1, the sputtering power is 60 W, and growth time is 18 hours.

In S3, SrCoO_{2.5} thin film with thickness of 30 nm is grown on the gadolinium-doped ceric oxide thin film by using the magnetron sputtering thin film growth process.

According to embodiments of the present disclosure, process conditions for manufacturing the channel layer are as follows: strontium cobaltate is used as the target, the distance between the target and the substrate is 5 cm, the temperature of the substrate is 750 °C, the total pressure of the vacuum chamber is 12 Pa, the flow ratio of argon to oxygen introduced is 9:1, the sputtering power is 50W, and the growth time is 20 minutes.

In S4, the SrCoO_{2.5} thin film is etched into a size of 100 µm in length and 50 µm in width by the argon ion etching process as the channel layer.

In S5, the chromium/gold (Cr/Au) composite film is deposited as the source electrode and the drain electrode on the surface on which the gadolinium-doped ceric oxide thin film is used as the gate dielectric layer and which is not covered by the channel layer and on a part of the channel layer by using the electron beam evaporation process. The chromium (Cr) film has a thickness of 5 nm and an evaporation rate of 0.1 angstrom per second (Å/s); the gold (Cr/Au) film has a thickness of 50 nm and an evaporation rate of 0.3 Å/s.

According to embodiments of the present disclosure, a field-effect transistor with a back gate structure in which a gadolinium-doped ceric oxide solid-state oxygen ionic conductor film is used as the gate dielectric layer and SrCoO_{2.5} thin film is used as the channel layer may be acquired through the above-mentioned steps.

In order to verify the regulation performance of the field-effect transistor on the channel material, the device is placed in a comprehensive physical property measurement system (PPMS), vacuum is pumped to less than 1 millibar, temperature is stabilized at 300 K, the bias voltage is applied between the gate electrode and the source electrode by using a digital source meter, and the resistance of the channel material is measured by using a lock-in amplifier. For example, FIG. 4 schematically shows the temperature dependent resistance of the channel material SrCoO_{2.5} thin film under different gate voltages according to Embodiment 2 of the present disclosure.

As shown in FIG. 4, when no bias voltage is applied, the sample is a strong insulator. When a negative bias voltage is applied to the sample, under the applied electric field, oxygen ions in the gadolinium-doped ceric oxide thin film are injected into the sample, the sample is hole-doped. At the same time, the oxygen content of the sample is changed, and the sample gradually changes from an insulating state to a metallic state. A further measurement shows that the sample changes from an antiferromagnetic insulator to a ferromagnetic metal, and the room temperature resistance of the sample decreases by four orders of magnitude.

From an experimental result, it can be seen that the physical properties of the channel material has been well regulated by the electric field, which shows the excellent performance of the solid oxygen ionic conductor based field-effect transistor.

### Embodiment 2

In the embodiment, the material of the channel layer is Sr₂IrO₄ thin film, and a solid oxygen ionic conductor based field-effect transistor thereof is manufactured according to the following steps S1 to S4.

In S1, niobium-doped strontium titanate (Nb doped SrTiO₃) is selected as the substrate with a thickness of 0.5 mm and a size of 5×5 mm², and the oxygen plasma cleaning is performed at a power of 150 W for 10 minutes.

In S2, the gadolinium-doped ceric oxide (Gd doped CeO₂) thin film with a thickness of 400 nm is grown as the gate dielectric layer on the niobium-doped strontium titanate substrate by using the magnetron sputtering film growth process.

According to embodiments of the present disclosure, process conditions for manufacturing the gate dielectric layer are as follows: the gadolinium-doped ceric oxide is used as the target, the distance between the target and the substrate is 10 cm, the temperature of the substrate is 600 °C, the total pressure of a vacuum chamber is 1.2 Pa, the flow ratio of argon to oxygen introduced is 2:1, the sputtering power is 50 W, and growth time is 8 hours.

In S3, the Sr₂IrO₄ thin film grown on a water-soluble substrate is transferred to the polydimethylsiloxane (PDMS) thin film by using a wet transfer method, a thin film sample with a thickness of 8 unit cells, a length of 20 µm and a width of 15 µm is selected under an optical microscope, and then the sample is transferred using a transfer table from the polydimethylsiloxane thin film to the surface on which the gadolinium-doped ceric oxide thin film is used as the gate dielectric layer as the channel layer by using a dry transfer method.

In S4, an indium tin oxide/gold (ITO/Au) composite film is deposited as the source electrode and the drain electrode on the surface on which the gadolinium-doped ceric oxide thin film is used as the gate dielectric layer and which is not covered by the channel layer and on a part of the channel layer by using the electron beam evaporation process. The indium tin oxide (ITO) film has a thickness of 10 nm and an evaporation rate of 0.2 angstrom per second (Å/s). The gold (Au) film has a thickness of 50 nm and an evaporation rate of 0.3 Å/s, and the temperature of a plating plate is 60 °C.

According to embodiments of the present disclosure, a field-effect transistor with a back gate structure in which a gadolinium-doped ceric oxide solid-state oxygen ionic conductor film is used as the gate dielectric layer and the Sr₂IrO₄ thin film is used as the channel layer may be acquired through the above-mentioned steps.

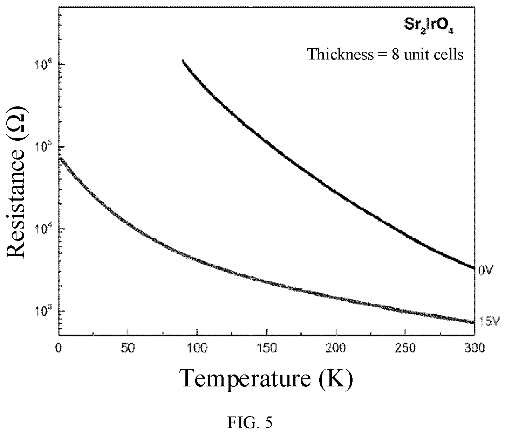

In order to verify the regulation performance of the field-effect transistor on the channel material, the device is placed in a comprehensive physical property measurement system (PPMS), vacuum is pumped to less than 1 millibar, temperature is stabilized at 300 K, the bias voltage is applied between the gate electrode and the source electrode by using a digital source meter, and the resistance of the channel material is measured by using a lock-in amplifier. For example, FIG. 5 schematically shows the temperature dependent resistance of the channel material Sr₂IrO₄ thin film under different gate voltages according to Embodiment 3 of the present disclosure.

As shown in FIG. 5, when no bias voltage is applied, the sample is a strong insulator. When a positive bias is applied to the sample, under the applied electric field, oxygen ions in the gadolinium-doped ceric oxide thin film may be far away from the sample, leaving a positive charge background near the sample, and will electrostatically regulate electrons to gather on the surface of the sample near the dielectric layer, so as to conduct electron doping on the sample. When the electric field increases to a certain level, oxygen in the sample may be removed, and at the same time, the oxygen content of the sample may also be changed, gradually weakening the insulation of the sample.

From an experimental result, it can be seen that although the electric field regulation may not change the sample from an insulating state to a metallic state, the room temperature resistance of the sample has decreased by nearly an order of magnitude, and the low temperature resistance has decreased by several orders of magnitude. This shows that the electric field well regulates the physical properties of the channel material, and shows the excellent performance of the solid oxygen ionic conductor based field-effect transistor.

The above-mentioned specific embodiments further describe the objectives, technical solutions and beneficial effects of the present invention in detail. It should be understood that the above are only specific embodiments of the present invention and are not intended to limit the present invention, which is defined by the subject-matter of the appended independent claims 1 and 5.

## Claims

1. A solid oxygen ionic conductor based field-effect transistor, comprising:
a substrate (1);
a gate dielectric layer (2) located on the substrate (1), wherein the gate dielectric layer (2) is a solid oxygen ionic conductor thin film;
a channel layer (3) covered on a part of the gate dielectric layer (2); and
a source electrode (4) and a drain electrode (5) respectively located on the gate dielectric layer (2) not covered by the channel layer (3) and on a part of the channel layer (3),
**characterized in that**
the material of the channel layer (3) is an oxide thin film or thin flake, comprising one of: strontium cobaltate, or strontium iridium oxide; and the thickness of the channel layer (3) is in a range of 5 nm to 30 nm.

2. The solid oxygen ionic conductor based field-effect transistor according to claim 1, wherein the substrate (1) is a metal conductive substrate, comprising one of niobium-doped strontium titanate or indium tin oxide conductive glass.

3. The solid oxygen ionic conductor based field-effect transistor according to claim 1, wherein the material of the solid oxygen ion conductor thin film is gadolinium-doped ceric oxide; and the thickness of the gate dielectric layer (2) is in a range of 400 nm to 1 µm.

4. The solid oxygen ionic conductor based field-effect transistor according to claim 1, wherein both of the source and the drain electrodes are one of the metal elemental films or indium tin oxide conductive films.

5. A method of manufacturing the solid oxygen ionic conductor based field-effect transistor according to any one of claims 1 to 4, comprising:
providing (S201) a metal conductive substrate as a gate electrode of the solid oxygen ionic conductor based field-effect transistor;
manufacturing (S202) the solid oxygen ionic conductor thin film based gate dielectric layer on the surface of the metal conductive substrate;
manufacturing (S203) the channel layer on the surface of the gate dielectric layer by using thin film growing and etching process or material mechanical peeling and transferring technology, wherein the channel layer is covered on a part of the gate dielectric layer, manufacturing (S204) the source electrode and the drain electrode on the gate dielectric layer not covered by the channel layer and on a part of the channel layer by using a coating process;
**characterized in that**
the material of the channel layer is an oxide thin film or thin flake, comprising one of: strontium cobaltate, or strontium iridium oxide; and the thickness of the channel layer is in a range of 5 nm to 30 nm.

6. The method according to claim 5, wherein the process of manufacturing the solid oxygen ionic conductor thin film based gate dielectric layer on the surface of the metal conductive substrate comprises one of magnetron sputtering or pulsed laser deposition.

7. The method according to claim 6, wherein the process of manufacturing the gate dielectric layer comprises:
a temperature at which the metal conductive substrate is heated is in a range of 600 °C to 750 °C;
a power density is in a range of 1.5 W/cm² to 3.5 W/cm²;
a distance between a target and the metal conductive substrate is in a range of 5 cm to 12 cm; and
a gas flow ratio of process gas to reaction gas is in a range of 2:1 to 3:1.

8. The method according to claim 7, wherein the process gas is argon and the reaction gas is oxygen.

9. The method according to claim 5, wherein the thin film growing and etching process comprises one of the argon ion etching process, reactive ion beam etching process or focused ion beam etching process; the material mechanical peeling and transferring technology comprises one of dry transfer or wet transfer; and the coating process comprises one of electron beam evaporation process or thermal evaporation process.

## Patentansprüche

1. Feldeffekttransistor auf Basis eines festen Sauerstoff-Ionenleiters, mit:
einem Substrat (1);
einer auf dem Substrat (1) angeordneten Gate-Dielektrikumsschicht (2), wobei die Gate-Dielektrikumsschicht (2) eine Dünnschicht aus einem festen Sauerstoff-Ionenleiter ist;
einer Kanalschicht (3), die einen Teil der Gate-Dielektrikumsschicht (2) bedeckt; und
einer Source-Elektrode (4) und einer Drain-Elektrode (5), die sich jeweils auf der Gate-Dielektrikumsschicht (2), die nicht von der Kanalschicht (3) bedeckt ist, und auf einem Teil der Kanalschicht (3) befinden,
**dadurch gekennzeichnet, dass**
das Material der Kanalschicht (3) eine Oxid-Dünnschicht oder ein dünnes Schuppenoxid ist, die/das aufweist: Strontiumkobaltat oder Strontiumiridiumoxid; und
die Dicke der Kanalschicht (3) in einem Bereich von 5 nm bis 30 nm liegt.

2. Feldeffekttransistor auf Basis eines festen Sauerstoff-Ionenleiters nach Anspruch 1, wobei das Substrat (1) ein metallisch leitfähiges Substrat ist, das entweder mit Niob dotiertes Strontiumtitanat oder Indiumzinnoxid-Leitglas aufweist.

3. Feldeffekttransistor auf Basis eines festen Sauerstoff-Ionenleiters nach Anspruch 1, wobei das Material der Dünnschicht aus festem Sauerstoff-lonenleiter Gadolinium-dotiertes Ceroxid ist; und
die Dicke der Gate-Dielektrikumsschicht (2) im Bereich von 400 nm bis 1 µm liegt.

4. Feldeffekttransistor auf Basis eines festen Sauerstoff-Ionenleiters nach Anspruch 1, wobei sowohl die Source- als auch die Drain-Elektrode entweder eine Metallelementschicht oder eine leitfähige Indiumzinnoxidschicht sind.

5. Verfahren zur Herstellung des auf einem festen Sauerstoff-lonenleiter basierenden Feldeffekttransistors nach einem der Ansprüche 1 bis 4, mit:
Bereitstellen (S201) eines metallischen leitfähigen Substrats als Gate-Elektrode des auf einem festen Sauerstoffionenleiter basierenden Feldeffekttransistors;
Herstellen (S202) der auf einer Dünnschicht aus einem festen Sauerstoff-Ionenleiter basierenden Gate-Dielektrikumsschicht auf der Oberfläche des metallischen leitfähigen Substrats;
Herstellen (S203) der Kanalschicht auf der Oberfläche der Gate-Dielektrikumsschicht unter Verwendung eines Dünnschichtwachstums- und Ätzverfahrens oder einer Technik zum mechanischen Ablösen und Übertragen von Material, wobei die Kanalschicht einen Teil der Gate-Dielektrikumsschicht bedeckt;
Herstellen (S204) der Source-Elektrode und der Drain-Elektrode auf der nicht von der Kanalschicht bedeckten Gate-Dielektrikumsschicht und auf einem Teil der Kanalschicht unter Verwendung eines Beschichtungsverfahrens;
**dadurch gekennzeichnet, dass**
das Material der Kanalschicht eine Oxid-Dünnschicht oder ein dünnes Schuppenoxid ist, das aufweist: Strontiumkobaltat oder Strontiumiridiumoxid; und
die Dicke der Kanalschicht im Bereich von 5 nm bis 30 nm liegt.

6. Verfahren nach Anspruch 5, wobei der Prozess zur Herstellung der auf einem festen Sauerstoff-Ionenleiter-Dünnfilm basierenden Gate-Dielektrikumsschicht auf der Oberfläche des metallischen leitfähigen Substrats Magnetron-Sputtern oder gepulste Laserdeposition umfasst.

7. Verfahren nach Anspruch 6, wobei der Herstellungsprozess der Gate-Dielektrikumsschicht aufweist:
eine Temperatur, auf die das metallische leitfähige Substrat erhitzt wird, liegt im Bereich von 600 °C bis 750 °C;
eine Leistungsdichte liegt im Bereich von 1,5 W/cm² bis 3,5 W/cm²;
ein Abstand zwischen einem Target und dem metallischen leitfähigen Substrat liegt in einem Bereich von 5 cm bis 12 cm; und
ein Gasdurchflussverhältnis von Prozessgas zu Reaktionsgas liegt in einem Bereich von 2:1 bis 3:1.

8. Verfahren nach Anspruch 7, wobei das Prozessgas Argon und das Reaktionsgas Sauerstoff ist.

9. Verfahren nach Anspruch 5, wobei das Dünnschichtwachstums- und Ätzpverfahren einen Argon-Ionen-Ätzverfahren, ein reaktives Ionenstrahl-Ätzverfahren oder ein fokussiertes lonenstrahl-Ätzverfahren umfasst;
wobei die Technik zum mechanischen Ablösen und Übertragen des Materials eine Trockenübertragung oder eine Nassübertragung umfasst; und
das Beschichtungsverfahren ein Elektronenstrahl-Verdampfungsverfahren oder ein thermisches Verdampfungsverfahren umfasst.

## Revendications

1. Transistor à effet de champ à base de conducteur d'ions d'oxygène solide, comprenant:
un substrat (1);
une couche diélectrique de grille (2) située sur le substrat (1), dans lequel la couche diélectrique de grille (2) est un film mince conducteur d'ions d'oxygène solide;
une couche de canal (3) recouvrant une partie de la couche diélectrique de grille (2); et
une électrode de source (4) et une électrode de drain (5) situées respectivement sur la couche diélectrique de grille (2) non recouverte par la couche de canal (3) et sur une partie de la couche de canal (3),
**caractérisé en ce que** le matériau de la couche de canal (3) est un film mince ou un flocon mince d'oxyde, comprenant l'un des éléments suivants: du cobaltate de strontium ou de l'oxyde d'iridium et de strontium; et l'épaisseur de la couche de canal (3) est comprise entre 5 nm et 30 nm.

2. Transistor à effet de champ à conducteur d'ions d'oxygène solide selon la revendication 1, dans lequel le substrat (1) est un substrat conducteur métallique, comprenant l'un parmi le titanate de strontium dopé au niobium ou le verre conducteur à base d'oxyde d'indium-étain.

3. Transistor à effet de champ à conducteur d'ions d'oxygène solide selon la revendication 1, dans lequel le matériau du film mince conducteur d'ions d'oxygène solide est de l'oxyde cérique dopé au gadolinium; et l'épaisseur de la couche diélectrique de grille (2) est comprise entre 400 nm et 1 pm.

4. Transistor à effet de champ à conducteur d'ions d'oxygène solide selon la revendication 1, dans lequel les électrodes de source et de drain sont toutes deux l'un des films métalliques élémentaires ou des films conducteurs à base d'oxyde d'indium-étain.

5. Procédé de fabrication du transistor à effet de champ à conducteur d'ions d'oxygène solide selon l'une quelconque des revendications 1 à 4, comprenant:
la fourniture (S201) d'un substrat conducteur métallique en tant qu'électrode de grille du transistor à effet de champ à conducteur d'ions d'oxygène solide;
la fabrication (S202) de la couche diélectrique de grille à base de film mince de conducteur d'ions d'oxygène solide sur la surface du substrat conducteur métallique;
la fabrication (S203) de la couche de canal sur la surface de la couche diélectrique de grille à l'aide d'un procédé de croissance et de gravure de film mince ou d'une technologie de pelage et de transfert mécanique de matériaux, dans laquelle la couche de canal recouvre une partie de la couche diélectrique de grille,
la fabrication (S204) de l'électrode de source et de l'électrode de drain sur la couche diélectrique de grille non recouverte par la couche de canal et sur une partie de la couche de canal à l'aide d'un procédé de revêtement;
**caractérisé en ce que** le matériau de la couche de canal est un film mince ou un flocon mince d'oxyde, comprenant l'un des éléments suivants: cobaltate de strontium ou oxyde de strontium et d'iridium; et l'épaisseur de la couche de canal est comprise entre 5 nm et 30 nm.

6. Procédé selon la revendication 5, dans lequel le procédé de fabrication de la couche diélectrique de grille à base de film mince conducteur d'ions d'oxygène solide sur la surface du substrat conducteur métallique comprend l'un des procédés suivants : pulvérisation magnétron ou dépôt par laser pulsé.

7. Procédé selon la revendication 6, dans lequel le processus de fabrication de la couche diélectrique de grille comprend:
une température à laquelle le substrat conducteur métallique est chauffé est comprise entre 600°C et 750°C;
une densité de puissance comprise entre 1,5 W/cm²et 3,5 W/cm²;
une distance entre une cible et le substrat conducteur métallique comprise entre 5 cm et 12 cm; et
un rapport de débit de gaz entre le gaz de traitement et le gaz de réaction est compris entre 2:1 et 3:1.

8. Procédé selon la revendication 7, dans lequel le gaz de traitement est de l'argon et le gaz de réaction est de l'oxygène.

9. Procédé selon la revendication 5, dans lequel le procédé de croissance et de gravure de film mince comprend l'un des procédés suivants: procédé de gravure par ions argon, procédé de gravure par faisceau ionique réactif ou procédé de gravure par faisceau ionique focalisé; la technologie de pelage et de transfert mécanique des matériaux comprend l'un des procédés suivants: transfert à sec ou transfert humide; et le procédé de revêtement comprend l'un des procédés suivants: procédé d'évaporation par faisceau d'électrons ou procédé d'évaporation thermique.
